Europäisches Patentamt

European Patent Office

Office européen des brevets

(11) Numéro de publication: **0 166 637**
A1

(12) **DEMANDE DE BREVET EUROPEEN**

(21) Numéro de dépôt: **85401022.0**

(22) Date de dépôt: **23.05.85**

(51) Int. Cl.⁴: **G 03 B 41/00,** G 06 F 15/70

(30) Priorité: **28.05.84 FR 8408334**

(43) Date de publication de la demande: **02.01.86**
**Bulletin 86/1**

(84) Etats contractants désignés: **AT BE CH DE GB IT LI LU NL SE**

(71) Demandeur: **MICRO-CONTROLE, Société Anonyme dite:, Z.I. de St. Guénault, F-91005 Evry (FR)**

(72) Inventeur: **Lepareur, Michel, 9, rue du Prince de Condé, F-95320 St-Leu-La-Foret (FR)**

(74) Mandataire: **Bonnetat, Christian et al, Cabinet PROPI Conseils 23 rue de Léningrad, F-75008 Paris (FR)**

(54) **Procédé et dispositif pour la reconnaissance d'un motif particulier d'une image.**

(57) Selon l'invention, on recherche le maximum de la fonction d'intercorrélation d'un signal de référence, correspondant au balayage d'un motif de base à travers une fente (18, 19), et d'un signal de reconnaissance, correspondant à un balayage d'une image contenant ledit motif, dans des conditions identiques au premier balayage.

EP 0 166 637 A1

ACTORUM AG

Procédé et dispositif pour la reconnaissance d'un motif
particulier d'une image.

La présente invention concerne un procédé et un dispositif
pour la reconnaissance d'un motif particulier d'une image.
Quoique non exclusivement, elle est particulièrement
appropriée à être mise en oeuvre pour l'alignement, suivant
au moins un axe, d'un objet par rapport à un objet semblable
pris pour référence et elle sera ci-après plus particulièrement expliquée à l'aide d'un exemple particulier.

On sait que la fabrication des circuits intégrés implique de
nombreuses manipulations des plaquettes semi-conductrices
dans lesquelles ils sont réalisés, ces plaquettes devant à
différents stades du processus de fabrication être alignées
précisément par rapport à au moins un, et en général deux,
axes de référence d'une machine de traitement.

Actuellement, la méthode d'alignement la plus répandue
consiste à superposer, à travers un microscope d'observation, les images de motifs de référence qui sont gravés sur
les plaquettes semi-conductrices et sur un réticule. L'oeil
de l'opérateur peut être remplacé par un ensemble comprenant une caméra et un écran de télévision.

Une technique plus élaborée consiste à traiter le signal
vidéo issu du tube vidicon d'une caméra, d'une manière
analogique ou numérique, afin d'obtenir une information
utilisable par des circuits électroniques d'asservissement.
Certains dispositifs utilisent par exemple le balayage d'une
croix de Saint André pour déterminer l'écart à l'alignement
qui se traduit par un déphasage entre les fronts des
signaux.

L'inconvénient majeur de ces procédés est qu'ils sont
inutilisables si les plaquettes semi-conductrices ne portant
pas les motifs de référence particuliers de l'appareil
d'alignement.

0166637

Une autre méthode consiste à superposer l'image d'une partie des motifs fonctionnels du circuit et une image équivalente prise comme référence. Cette référence peut se trouver sur un support physique ; le contrôle de coïncidences se fait alors d'une façon manuelle avec un microscope à deux objectifs du type "split-field". L'image de référence peut aussi avoir un support virtuel, comme la mémoire d'un calculateur ; la plaquette est alors observée à l'aide d'une caméra de télévision, son image est digitalisée, puis entrée dans le calculateur pour comparaison.

Cette dernière technique a l'inconvénient d'être complexe et de mettre en oeuvre des équipements coûteux.

Pour pallier ces inconvénients, l'invention a donc pour objet un procédé et un dispositif de reconnaissance d'image permettant de réaliser un système d'alignement automatique et simple qui ne nécessite aucune marque particulière sur les plaquettes et qui peut être adapté à de nombreuses machines de traitement.

A cette fin, selon l'invention, le procédé pour la reconnaissance d'un motif particulier d'une image, est remarquable en ce que :

- dans une étape préliminaire, on éclaire un modèle de ladite image et on observe ledit motif à travers au moins une fente, on imprime entre ladite fente et ledit modèle de l'image un mouvement de déplacement relatif de direction transversale à ladite fente et d'amplitude suffisante pour balayer ledit motif, on transforme en continu pendant la durée dudit déplacement relatif l'intensité du faisceau lumineux traversant ladite fente en un signal électrique de référence et on enregistre ledit signal électrique de référence comme fonction dudit déplacement relatif ;

0166637

- puis, dans une étape de reconnaissance dudit motif, on éclaire dans des conditions identiques à celles de l'éclairage précédent, une zone d'une image à reconnaître contenant ledit motif et préorientée de façon semblable audit modèle par rapport à ladite fente et on observe ladite zone à travers ladite fente, on imprime entre ladite fente et ladite zone un mouvement de déplacement relatif de même direction que le précédent et d'amplitude suffisante pour balayer la totalité de la zone, on transforme en continu pendant la durée de ce dernier déplacement relatif l'intensité du faisceau lumineux traversant ladite ladite fente en un signal électrique d'exploration et on recherche le maximum de la fonction d'intercorrélation dudit signal électrique de référence avec ledit signal électrique d'exploration en fonction du décalage parallèlement à la direction desdits déplacements relatifs, pouvant exister entre le motif dudit modèle et celui de ladite zone.

On voit donc que, selon l'invention, on localise le signal électrique de référence dans le signal électrique d'exploration, de sorte que l'on détermine la position dudit motif particulier dans la zone d'image explorée pendant l'étape de reconnaissance.

Puisque ladite zone d'image examinée pendant l'étape de reconnaissance contient un motif identique à celui examiné pendant l'étape préliminaire et que l'examen de ces deux motifs s'effectue de façon identique, il est certain qu'une portion du signal d'exploration présente de grandes similitudes avec ledit signal de référence. Pour localiser cette portion du signal d'exploration, on cherche le maximum de la fonction d'intercorrélation du signal de référence avec le signal d'exploration en fonction du décalage, parallèlement à la direction desdits déplacements relatifs, du motif examiné pendant l'étape de reconnaissance par

4

0166637

rapport au motif du modèle examiné pendant l'étape préliminaire. La recherche d'un tel maximum s'obtient en calculant la valeur de ladite fonction d'intercorrélation pour une pluralité de valeurs possibles du décalage. Lorsque ledit maximum est trouvé, on connait donc la valeur et le sens du décalage entre les deux motifs examinés successivement pendant l'étape préliminaire et l'étape de reconnaissance.

Il résulte de ce qui précède que le procédé de reconnaissance selon l'invention fournit automatiquement ledit décalage, de sorte qu'il est particulièrement approprié à être utilisé pour l'alignement du motif de ladite zone par rapport au motif dudit modèle.

En effet, le décalage ainsi déterminé peut alors servir de données à un dispositif de correction de position de l'image observée dans l'étape de reconnaissance, pour amener celle-ci en alignement parfait avec le modèle observé pendant l'étape préliminaire, parallèlement à la direction de déplacement.

En réalité, le plus souvent, l'alignement parallèlement à un axe est insuffisant et il est nécessaire de prévoir des corrections de position parallèlement à deux axes. Dans ce cas, le procédé selon l'invention met en oeuvre, pendant l'étape préliminaire et pendant l'étape de reconnaissance, deux fentes non parallèles et, de préférence, orthogonales.

Afin d'éviter, dans chacune desdites étapes, de réaliser deux balayages différents (un par fente), il est avantageux que les deux fentes balayent simultanément leur motif respectif, lors d'un unique déplacement relatif de direction comprise entre celles desdites fentes. Par exemple, la direction de cet unique déplacement peut être celle de la

5

bissectrice de l'angle formé par les deux fentes.

On voit ainsi que, grâce à l'invention, on peut réaliser l'alignement d'objets sur reconnaissance d'image avec apprentissage, sans utilisation de marques particulières sur lesdits objets. Par exemple, dans le cas de la fabrication de circuits intégrés, une première plaquette semi-conductrice est placée dans un appareil de traitement et les différents règlages sont effectués de façon que toutes les fonctions prévues puissent être exécutées dans de bonnes conditions. Le dispositif d'alignement selon l'invention reconnaît et mémorise la position de cette plaquette afin d'être capable de placer automatiquement les suivantes de la même façon. Pour cela, une image agrandie de la surface de la première plaquette est formée dans un plan où se trouve une fente longue et fine. La lumière transmise par cette fente est caractéristique de la réflectivité de la surface correspondante de la plaquette et donc des motifs (résultant de diverses diffusions, dépôts, etc...) qui s'y trouvent. La lumière est ensuite transformée en tension électrique par un détecteur électro-optique. Un balayage de l'image devant la fente et transversalement à celle-ci provoque une variation du signal électrique de sortie qui est alors échantillonné, digitalisé et mis en mémoire d'un calculateur.

Sur les plaquettes suivantes qui sont introduites dans l'appareil, cette même opération de balayage est répétée mais cette fois avec une amplitude plus grande.

Ces nouvelles plaquettes étant déjà préalignées, c'est-à-dire que leur position n'est pas très éloignée de celle de la première, il existe une portion des signaux enregistrés qui présente de grandes similitudes avec le premier signal. Cette portion, qui correspond à la surface qui a été balayée sur la première plaquette, est localisée, comme indiqué

6

0166637

ci-dessus, en cherchant les maxima des fonctions d'intercor rélation du premier signal avec les suivants.

En conséquence de ce qui précède, un dispositif pour la reconnaissance d'un motif particulier d'une image, est remarquable en ce qu'il comporte :

- un support mobile dans au moins une direction sous l'action d'un actuateur, pour supporter successivement un modèle de ladite image et une image à reconnaître contenant ledit motif,

- un dispositif d'éclairage susceptible d'éclairer ledit support ;

- au moins une fente de direction transversale par rapport la direction de déplacement dudit support ;

- un système optique pour adresser à ladite fente le faisceau lumineux réfléchi par ledit modèle et par ladite image à reconnaître ;

- des moyens photoélectriques pour transformer le faisceau lumineux réfléchi en signal électrique ; et

- des moyens de calcul pour déterminer le maximum de la fonction d'intercorrélation du signal électrique correspondant audit modèle avec le signal électrique correspondant à ladite image à reconnaître en fonction du décalage, parallèlement à la direction du déplacement dudit support, pouvant exister entre le motif du modèle et celui de ladite image à reconnaître.

Avantageusement, ce dispositif comporte des moyens de commande dudit actuateur, contrôlés par lesdits moyens de calcul de façon à déplacer ledit support pour annuler ledit décalage.

De préférence, le dispositif selon l'invention comporte deux fentes non parallèles et ledit système optique adresse simultanément aux deux fentes ledit faisceau lumineux réfléchi, des moyens photoélectriques étant associés à chacune des deux fentes et des actuateurs étant prévus pour pouvoir déplacer ledit support dans deux directions transversales auxdites fentes.

Dans un mode de réalisation avantageux, ledit support est une table XY et les deux fentes sont orthogonales entre elles. Les actuateurs de la table XY peuvent alors être commandés simultanément pour qu'il en résulte un mouvement relatif du support par rapport auxdites fentes, de direction parallèle à la bissectrice de l'angle formé entre elles par lesdites fentes.

Les figures du dessin annexé feront bien comprendre comment l'invention peut être réalisée.

Les figures 1 à 4 illustrent le procédé de la présente invention.

La figure 5 donne le schéma synoptique d'un mode de réalisation d'un dispositif selon l'invention.

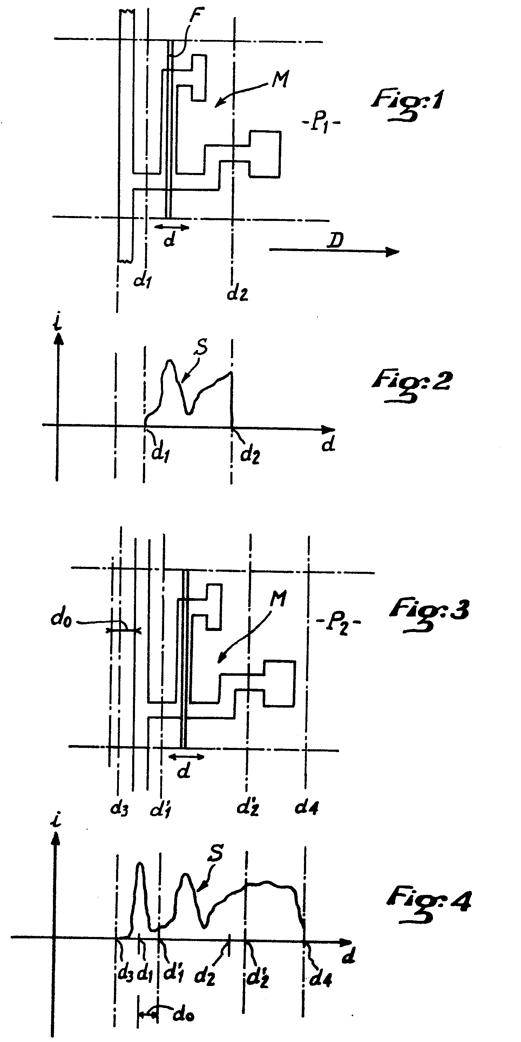

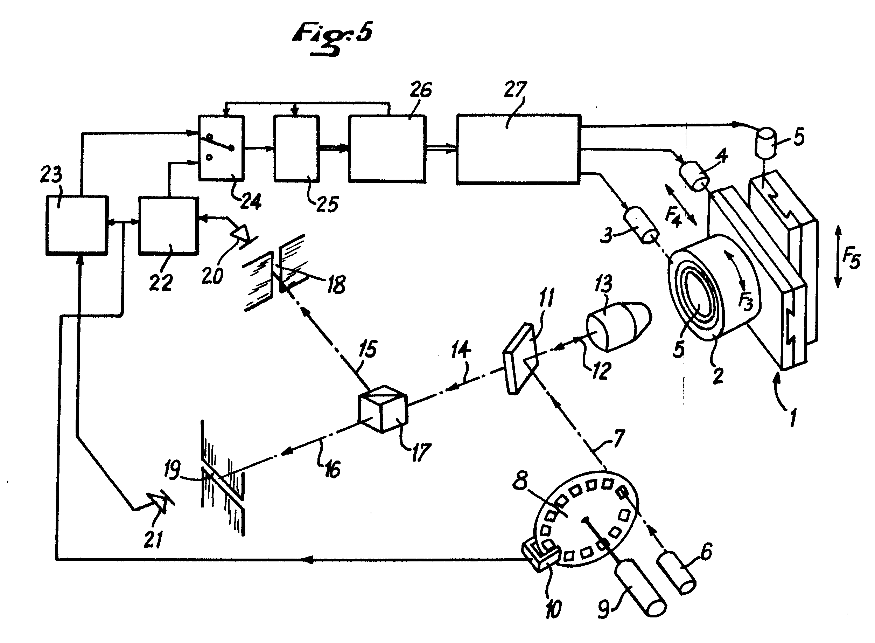

Sur la figure 1, on a représenté le motif M d'une première pièce $P_1$, par exemple un circuit intégré, et une fente F, à travers laquelle on observe ledit motif. Sur cette figure 1, ainsi d'ailleurs que sur la figure 4, on a représenté la fente F en superposition sur le motif M, en omettant, à des

0166637

fins de clarté, de cacher les parties dudit motif extérieures à ladite fente. Il va de soi qu'en réalité la fente F est pratiquée dans un écran dissimulant ledit motif, seule la partie de celui-ci en regard de ladite fente étant visible.

Le motif M de la pièce $P_1$ est éclairée, de sorte qu'un faisceau lumineux en forme de pinceau traverse la fente F.

Par ailleurs, un déplacement relatif, de direction D, peut être imprimé entre la pièce $P_1$ et la fente F, de sorte que celle-ci peut balayer le motif M entre les lignes $d_1$ et $d_2$.

Au cours d'un tel balayage, on mesure, à l'aide d'un dispositif photoélectrique, l'intensité $i$ du faisceau lumineux traversant la fente F en fonction de la distance $d$ du déplacement relatif. On obtient ainsi un signal électrique S, du type représenté sur la figure 2 et caractéristique du motif M.

Ensuite, la pièce $P_1$ est remplacée par une pièce $P_2$, orientée de façon identique, comportant le même motif M (voir la figure 3) et on pratique un balayage du type précédent, mais commençant avant et finissant après celui de la pièce $P_1$. Sur la figure 3, on a illustré le balayage de la pièce $P_2$ commençant en $d_3$ et finissant en $d_4$, le motif M de cette pièce étant disposé entre $d'_1$ et $d'_2$. Ce nouveau balayage fournit le signal électrique montré par la figure 4, dont la portion comprise entre $d'_1$ et $d'_2$ est semblable au signal S de la figure 2.

Selon l'invention, on établit la fonction d'intercorrélation du signal S de la figure 2 avec le signal de la figure 4 et on cherche le maximum de cette fonction d'intercorrélation en fonction du décalage do, parallèle à D, existant entre le motif M de la figure 3 et le motif M de la figure 4. Lorsque ce maximum est obtenu, on connait donc la valeur réelle du décalage do ainsi que son sens. A partir de cette détermination de do, on peut donc agir sur la pièce $P_2$ pour annuler ledit décalage do et amener le motif M de la pièce $P_2$ en alignement parfait (parallèlement à D) avec le motif M de la pièce $P_1$.

Sur la figure 5, on a représenté un dispositif selon ⊥'invention mettant en oeuvre le procédé illustré par les figures 1 à 4, à l'aide de deux fentes.

Le dispositif de la figure 5 comporte une table X,Y 1, portant un support 2 pouvant éventuellement tourner sur lui-même (flèche F3), par rapport à ladite table X,Y sous l'action d'un moteur ou vérin 3. Les autres parties mobiles de la table X,Y peuvent se déplacer (flèches F4 et F5) sous l'action de moteurs ou vérins 4 et 5, respectivement.

La pièce P1 et la pièce P2 peuvent être successivement maintenues, en 5, sur le support 2, par exemple par succion. Une source lumineuse 6 émet un faisceau lumineux 7, qui est modulé par un modulateur à disque 8, entraîné en rotation par un moteur 9 et associé à un détecteur 10.

Le faisceau 7 est adressé à un miroir semi-réfléchissant 11, qui le réfléchit en un faisceau 12 adressé à la pièce 5 ($P_1$ ou $P_2$) à travers un objectif 13.

Le faisceau 12 se réfléchit sur la pièce 5 et donne naissance à un faisceau 14 qui traverse l'objectif 13 et le miroir semi-réfléchissant 11 et qui est séparé en deux faisceaux 15 et 16 par un séparateur 17. Le faisceau 15 est adressé à une fente 18 parallèle à la direction de déplacement F4, tandis que le faisceau 16 est adressé à une fente 19 parallèle à la direction de déplacement F5. Derrière les fentes 18 et 19 sont disposés des dispositifs photoélectriques 20 ou 21, respectivement, qui fournissent des signaux électriques adressés à des détecteurs synchrone: 22 ou 23, pilotés par le détecteur 10.

Par l'intermédiaire d'un commutateur 24 et d'un convertisseur analogique-numérique 25, lesdits signaux sont transmis à un micro-processeur 26, qui par l'intermédiaire d'un dispositif de commande 27, peut actionner les actuateurs 4 et 5, et éventuellement l'actuateur 3.

Ainsi, dans une étape préliminaire et de la façon décrite ci-dessus, le microprocesseur 26 peut déplacer la pièce $P_1$ (se trouvant en 5) orthogonalement aux fentes 18 et 19 respectivement pour acquérir deux signaux, du type de signa S de la figure 2. Ensuite, la pièce $P_2$ est examinée de manière analogue sous la commande du microprocesseur 26, pour obtenir deux signaux, du type du signal de la figure 4 Pour chacun de ces deux derniers signaux, le microprocesseu 26 effectue les calculs du maximum de la fonction d'inter-corrélation avec le premier signal S corespondant. Le microprocesseur détermine donc les deux décalages do, parallèlement aux fentes 18 et 19 et il commande les actuateurs 4 et 5, par l'intermédiaire du dispositif 27, pour les annuler.

On comprendra que par action simultanée des actuateurs 4 et 5, le microprocesseur 26 peut commander simultanément le balayage des fentes 18 et 19, parallèlement à la bissectric de l'angle formé par celles-ci.

0166637

REVENDICATIONS

1 - Procédé pour la reconnaissance d'un motif particulier d'une image,
caractérisé en ce que :

- dans une étape préliminaire, on éclaire un modèle de ladite image et on observe ledit motif à travers au moins une fente, on imprime entre ladite fente et ledit modèle de l'image un mouvement de déplacement relatif de direction transversale à ladite fente et d'amplitude suffisante pour balayer ledit motif, on transforme en continu pendant la durée dudit déplacement relatif l'intensité du faisceau lumineux traversant ladite fente en un signal électrique de référence et on enregistre ledit signal électrique de référence comme fonction dudit déplacement relatif ;

- puis, dans une étape de reconnaissance dudit motif, on éclaire dans des conditions identiques à celles de l'éclairage précédent, une zone d'une image à reconnaître contenant ledit motif et préorientée de façon semblable audit modèle par rapport à ladite fente et on observe ladite zone à travers ladite fente, on imprime entre ladite fente et ladite zone un mouvement de déplacement relatif de même direction que le précédent et d'amplitude suffisante pour balayer la totalité de la zone, on transforme en continu pendant la durée de ce dernier déplacement relatif l'intensité du faisceau lumineux traversant ladite fente en un signal électrique d'exploration et on recherche le maximum de la fonction d'intercorrélation dudit signal électrique de référence avec ledit signal électrique d'exploration en fonction du décalage, parallèlement à la direction desdits déplacements relatifs, pouvant exister entre le motif dudit modèle et celui de ladite zone.

12

0166637

2 - Procédé selon la revendication 1,
caractérisé en ce que le décalage correspondant au maximum
de ladite fonction d'intercorrélation est utilisé pour
amener le motif observé pendant l'étape de reconnaissance en
alignement avec le motif observé pendant l'étape préliminaire.

3 - Procédé selon l'une quelconque des revendications 1 ou
2,
caractérisé en ce qu'il met en oeuvre deux fentes non
parallèles.

4 - Procédé selon la revendication 3,
caractérisé en ce que lesdites fentes sont orthogonales
entre elles.

5 - Procédé selon l'une des revendications 3 ou 4,
caractérisé en ce que les deux fentes balayent simultanément
leur motif respectif, lors d'un unique déplacement relatif
de direction comprise entre celles desdites fentes.

6 - Dispositif pour la reconnaissance d'un motif particulier
d'une image,
caractérisé en ce qu'il comporte :

- un support (2), mobile dans au moins une direction sous
l'action d'un actuateur (4,5), pour supporter successivement
un modèle de ladite image ($P_1$) et une image à reconnaître ($P_2$)
contenant ledit motif (M) ;

- un dispositif d'éclairage (6) susceptible d'éclairer ledit
support,

0166637

- au moins une fente (18,19) de direction transversale par rapport à la direction de déplacement dudit support,
- un système optique (11,13,17) pour adresser à ladite fente le faisceau lumineux (14) réfléchi par ledit modèle et par ladite image à reconnaître,
- des moyens photoélectriques (20,21) pour transformer le faisceau lumineux réfléchi en signal électrique ; et
- des moyens de calcul (26) pour déterminer le maximum de la fonction d'intercorrélation du signal électrique correspondant audit modèle avec le signal électrique correspondant à ladite image à reconnaître en fonction du décalage, parallèlement à la direction du déplacement dudit support, pouvant exister entre le motif du modèle et celui de ladite image à reconnaître.

7 - Dispositif selon la revendication 6, caractérisé en ce qu'il comporte des moyens de commande (27) dudit actuateur (4,5), contrôlés par lesdits moyens de calcul (22) de façon à déplacer ledit support pour annuler ledit décalage.

8 - Dispositif selon l'une des revendications 6 ou 7, caractérisé en ce qu'il comporte deux fentes (18,19) non parallèles et ledit système optique adresse simultanément aux deux fentes ledit faisceau lumineux réfléchi, des moyens photoélectriques (10,11) étant associés à chacune des deux fentes et des actuateurs (4,5) étant prévus pour pouvoir déplacer ledit support des deux directions transversales auxdites fentes.

9 - Dispositif selon l'une des revendications 6 à 8, caractérisé en ce que ledit support est une table XY et les deux fentes (18,19) sont orthogonales entre elles.

0166637

10 - Dispositif selon la revendication 9, caractérisé en ce que les actuateurs de la table XY sont commandés simultanément pour qu'il en résulte un mouvement relatif du support par rapport auxdites fentes, de direction parallèle à la bissectrice de l'angle formé entre elles par lesdites fentes.

0166637

Fig:1

*-P₁-*

Fig:2

Fig:3

*-P₂-*

Fig:4

Fig. 5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.⁴) |
|---|---|---|---|
| X | FR-A-2 271 541 (THE BENDIX CORPORATION) * Page 2, lignes 5-11; page 2, lignes 27-31; page 5, lignes 19-23; page 6, lignes 3-6; page 9, lignes 2-4; page 9, lignes 13-31; revendications 1,2; figure 1 * | 1 | G 03 B 41/00 G 06 F 15/70 |
| Y | | 6,7 | |
| Y | US-A-4 153 371 (KOIZUMI et al.) * Colonne 5, lignes 1-9; figure 4A * | 6,7 | |
| Y | BE-A- 740 192 (TEXAS INSTRUMENTS INC.) * Page 7, ligne 1 - page 8, ligne 8 * | 1,2,6, 7 | DOMAINES TECHNIQUES RECHERCHES (Int. Cl.⁴) |
| Y | EP-A-0 019 941 (HITACHI LTD.) * Page 2, ligne 22 - page 3, ligne 5; figures 1,4,5 * | 1,2,6, 7 | G 03 B 41 G 06 F 15 |
| A | US-A-4 041 286 (SANFORD) * Abrégé * | 1,6 | |

--- -/-

Le présent rapport de recherche a été établi pour toutes les revendications

| Lieu de la recherche | Date d'achèvement de la recherche | Examinateur |
|---|---|---|
| LA HAYE | 02-09-1985 | CIGOJ P.M. |

## DOCUMENTS CONSIDERES COMME PERTINENTS

Page 2

| Catégorie | Citation du document avec indication, en cas de besoin, des parties pertinentes | Revendication concernee | CLASSEMENT DE LA DEMANDE (Int Cl 4) |
|---|---|---|---|
| A | IBM TECHNICAL DISCLOSURE BULLETIN, volume 26, no. 10B, mars 1984, pages 5532-5533, New York, US; J.P. KIRK et al.: "Cross-correlation of mask and wafer for alignment and process control" <br> * En entier * <br><br> --- | 1,2 | |
| A | M. FRANCON: "Optique. Formation et traitement des images", 1972, pages 116-120, MASSON et Cie., Paris, FR <br> * Page 120, lignes 9-20 * <br><br> ----- | 1 | |
| | | | **DOMAINES TECHNIQUES RECHERCHES (Int. Cl.4)** |

Le présent rapport de recherche a été établi pour toutes les revendications

| Lieu de la recherche <br> LA HAYE | Date d'achèvement de la recherche <br> 02-09-1985 | Examinateur <br> CIGOJ P.M. |
|---|---|---|